# EUROPEAN PATENT SPECIFICATION

(11) **EP 3 125 270 B1**
(45) Date of publication and mention of the grant of the patent: **10.04.2019**
(21) Application number: 15178449.3
(22) Date of filing: 27.07.2015
(51) Int. Cl.: H01J 37/20, G01N 1/32

(54) **TEM SAMPLE MOUNTING GEOMETRY**
TEM-PROBENBEFESTIGUNGSGEOMETRIE
GÉOMÉTRIE DE MONTAGE D'ÉCHANTILLONS TEM

(43) Date of publication of application: 01.02.2017
(73) Proprietor: FEI Company, Hillsboro, OR 97124-5793 (US)
(72) Inventor: Foord, David, Portland, OR 97229 (US)
(74) Representative: Janssen, Francis-Paul

(56) References cited:
- JP-A- 2009 192 341
- US-A1- 2006 011 868
- US-A1- 2007 187 597
- US-A1- 2008 067 374
- US-A1- 2013 344 292

## Description

### Technical Field of the Invention

The present invention relates to methods for transmission electron microscope analysis, and obtaining orthogonal images of mounted samples.

### Background of the Invention

The density of integrated circuits (ICs) continues to dramatically increase due to the decrease in both the size of circuit features and components (e.g., transistors) and the pitch or distance between them. In order to develop reliable IC manufacturing processes, measure characteristic feature sizes, diagnose manufacturing defects, and perform quality control, integrated circuit manufacturers typically inspect integrated circuits or portions of integrated circuits via transmission or scanning transmission electron microscopes (TEM). As used herein, the term transmission electron microscope is intended to include scanning transmission electron microscope.

Most IC device components are structurally orthogonal, having characteristic lengths, widths, and depths. Typically, images, analytical maps are taken from one of these orthogonal directions and provide the necessary end data. Given the current size of such components, transmission electron microscopy is often the only effective way to visualize, inspect and measure the features and components of IC devices. Currently, such measurements are made from the inspection of thin cross-sectional slices or lamellae that are extracted from the ICs. Extracted lamellae are typically 30-100 nm thick in the viewing direction (i.e., the transmitted electron beam direction) but can be as thin as 10 nm or below for current technology nodes, and have a cross-sectional area between about 4um² and 16um². Various problems can occur when trying to extract thin lamellae from processed Si wafers including warping, bending, over-milling, amorphisation and so-called curtaining. These problems can, in turn, lead to poor IC device characterization, such as poor measurement of the characteristic sizes of IC device features or component. Moreover, since IC device features and components are three dimensional, their proper characterization requires inspection in all three dimensions, often requiring separate lamellae to be extracted in three different viewing directions. The separate lamellae in different orientations are extracted from different instances of the same feature, such as different one of identical memory cells.

TEM samples are viewed by transmitting a beam of electrons through the sample and detecting the transmitted electrons on the opposite side to form the image. The beam is typically orthogonal to the face of the lamella. In electron tomography, the sample (or beam) is tilted through a series of tilt angles, with an image formed at each of the different tilt angles, to provide data that can be used to mathematically reconstruct a three dimensional image. Because it is impossible to obtain a complete 180 degree tilt series of a lamella, a pillar-shaped sample is sometimes used for electron tomography. A pillar shaped sample has the disadvantage of having non-uniform thickness across the sample when viewed from any direction. JP 2009 192341A discloses a preparation method of a sliced sample for a TEM wherein four samples are loaded onto a sample stand having a mechanism rotating in a vertical plane with respect to the optical axis of an ion beam, and each sample is fixed separately at an angle of 90 degrees or more from an adjacent sample. US 2008/067374 discloses a specimen analyzing apparatus, such as a TEM, for analyzing an observing specimen, a specimen support (mesh) including a mesh electrode. Voltage is applied externally to the external voltage applying portions of the specimen through the mesh electrode. A pillar-shaped sample (see Fig. 9B) can be observed from plural directions. US 2006/011868 discloses a charged particle beam apparatus, comprising a transmission electron microscope. The apparatus is used for forming a sample of an object, extracting the sample from the object, and subjecting this sample to microanalysis including surface analysis and electron transparency analysis in a vacuum chamber. A needle is used as manipulator for extracting and rotating the sample.

### Summary of the Invention

An object of the invention is to provide three dimensional imaging of a thin sample.

The invention provides a method for obtaining orthogonal images of a sample in a charged particle beam apparatus, comprising:connecting a sample comprising three orthogonal observation faces that are not parallel to each other to a rotatable sample holder, the thickness of the sample orthogonal to each of the observation faces being less than 200 nm;rotating the rotatable sample holder to a plurality of angles, such that for each of the plurality of angles a different one of the three orthogonal observation faces is exposed to and normal to an electron beam generated by the charged particle beam apparatus;detecting, at each of the plurality of angles, the electrons from the electron beam that are transmitted through the sample for each of the three orthogonal observation faces; and generating three orthogonal images of the sample from the detected electrons transmitted through the sample at each of the three orthogonal observation faces.

The foregoing has outlined rather broadly the features and technical advantages of the present invention in order that the detailed description of the invention that follows may be better understood. Additional features and advantages of the invention will be described hereinafter. It should be appreciated by those skilled in the art that the conception and specific embodiments disclosed may be readily utilized as a basis for modifying or designing other structures for carrying out the same purposes of the present invention, as long as such equivalent constructions do not depart from the scope of the invention as set forth in the appended claims.

### Brief Description of the Drawings

For a more thorough understanding of the present invention, and advantages thereof, reference is now made to the following descriptions taken in conjunction with the accompanying drawings, in which:
FIG. 1 is an illustration of a method of mounting a bulk sample on a rotatable shaft to enable viewing three orthogonal sides of the sample in a TEM by rotating the shaft.
FIGS. 2A-2C show, in different rotational orientations, a sample having six faces, including three sets of orthogonal faces.
FIG. 3 is an illustration of one embodiment of mounting a sample on a sample holder.
FIG. 4 is an illustration of a second embodiment of mounting a sample on a sample holder.
FIG. 5 is an illustration of an alternative embodiment for extracting and mounting a sample on a sample holder.
FIG. 6 is an illustration of an embodiment of mounting a sample on a pin holder at an angle inside the imaging area.
FIG. 7 is an illustration of an embodiment of mounting a sample on a manipulator that is rotationally coupled via a gear to an arm.
FIGS. 8A-8B are schematic illustrations of two types of gears that can be used in some embodiments of the invention.

### Detailed Description of Preferred Embodiments

One way to overcome the various problems coincident with extracting 3 orthogonal lamellae from an IC device in order to characterize a given feature or component of the device is to instead extract a thick bulk sample from the device containing the desired feature or component, and use a TEM to tomographically reconstruct the thick bulk sample. Complete tomographic imaging, however, requires obtaining multiple image projections from multiple angles, and mathematically combining the information contained in the multiple image projections using time consuming image reconstruction algorithms. Fortunately, IC device manufacturers can often quickly and easily make component measurements or diagnose component defects and sources of component defects by simply viewing TEM images of an extracted bulk sample containing the component from three orthogonal directions. Obtaining three orthogonal TEM images rather than a full tomographically reconstructed image is advantageous since the individual TEM images have higher resolutions than those reconstructed from a TEM tomographic image series and can be obtained much more quickly.

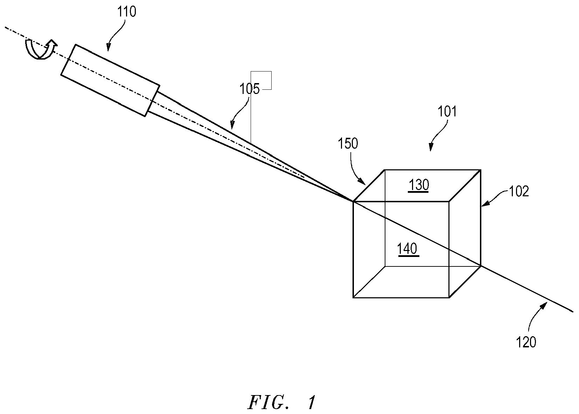

FIG. 1 is an illustration of a method of mounting a bulk sample on a rotatable shaft to enable viewing 3 orthogonal sides of the sample in a TEM by rotating the shaft. The sample 102 can be made of any material. For example, it can be obtained from an integrated circuit and made from the materials used to make integrated circuits. The sample 102 can be extracted from a larger piece of material using conventional TEM sample preparation techniques. For example, the sample 102 can be extracted in a focused ion beam (FIB) machine or a dual FIB/SEM machine using conventional ion beam milling techniques, such as those used to extract lamellae from larger pieces of material. In general, sample 102 should be dimensioned so that it is partially transparent to the electrons from a TEM electron beam so that a TEM image of the sample can be obtained by transmitting electrons through it. In one embodiment, the sample 102 is extracted in the approximate shape of a cube having a characteristic dimension that is between about 20 nm and 200 nm.

The sample 102 is mounted on a thin needle 105 in such a way that the symmetry axis 120 of the needle 105 passes through any two diametrically opposed apexes of the cubic sample 102. The sample 102 can be attached to the thin needle 105 using conventional methods, such as conventional focused ion beam welding techniques. In focused ion beam welding, as described for example in U.S. Pat. No. 4,876,112 to Kaito et al. for a "Process for Forming Metallic Patterned Film" and U.S. Pat. No. 5,104,684 to Tao et al. for "Ion Beam Induced Deposition of Metals, the sample 102 and needle 105 are brought into close proximity near the focus of an ion beam. A suitable gas precursor, such as an organometallic gas, is introduced into the region defined by the sample 102, needle 105 and ion beam. The ion beam activates the gas precursor, either directly or indirectly (e.g., by heating the sample 102 or needle 105), and causes the precursor to dissociate into a volatile and a non-volatile component. The volatile component is removed by the FIB machine's vacuum system, while the non-volatile component deposits on the sample 102 and needle 105, thereby building a material bridge between and connecting the two.

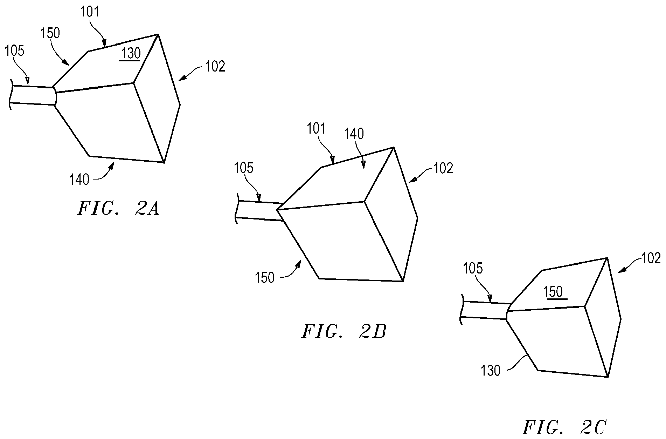

As shown in FIG. 2A, sample 102 has six faces, including three sets of orthogonal faces conveniently described by an initially top face 130, an initially front face 140 and an initially side face (currently obscured) 150. In an initial configuration, shown in FIG. 2A, an image of the sample 102 along a first orthogonal face 130 can be obtained by transmitting an electron beam 101 through the first orthogonal face 130. Next, the sample 102 is rotated through an angle of 120 degrees about the symmetry axes of needle 105 to which the sample 102 is attached. As shown in FIG. 2B, this rotation will expose a second orthogonal face 140 of sample 102 to the electron beam 101, allowing an image of sample 102 along the second orthogonal face 140 to be obtained. Finally, the sample 102 is rotated through an additional angle of 120 degrees about the symmetry axes of needle 105 to which sample 102 is attached. As shown in FIG. 2C, this rotation will expose a third orthogonal face 150 of sample 102 to the electron beam 101, allowing an image of sample 102 along the third orthogonal face 150 to be obtained.

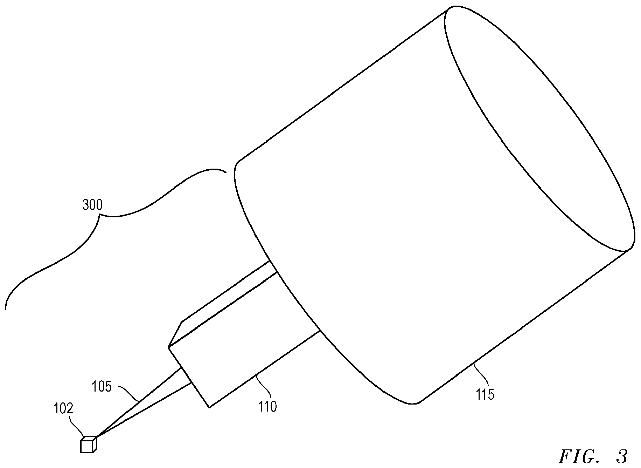

FIG. 3 is an illustration of one embodiment of mounting a sample 102 on a sample holder 300. The sample holder 300 consists of a conventional tomography pin holder 115 that has had a thin lamella 110 attached to it and in turn a very fine needle 105 attached to the thin lamella 110. In one embodiment, the sample holder can be formed as follows. A thin lamella 110 having an approximate width of 500 nm, an approximate height of 5 microns and an approximate initial length of 15 microns can be made in a FIB machine using conventional FIB lamella manufacturing methods such as ion beam milling. Next, the top portion or approximately 5 microns of the length of the lamella can be milled to create a thin, conically shaped needle 105 having a tip with an approximately 30 nm radius. The needle 105 can be made, for example, using convention FIB annular milling techniques much like those used for the manufacture of tomography pillars or atom probe microscope samples. In annular milling, described for example in 7,442,924 to Giannuzzi et al for "Repetitive Circumferential Milling for Sample Preparation" in a FIB is used to etch a sequence of circular paths that are confined to an annulus having an inner and outer radius. The dwell time of the FIB along a given circular path is made dependent upon the radius of the path, so that the dwell time is longer for larger radial paths than for shorter radial paths. Since the amount of material removed by the FIB is a function of dwell time, more material is removed from larger radial paths than from smaller radial paths; and a conically shaped needle is thereby created. If the outer radius of the annulus is about 500 nm, the inner radius is about 30 nm, and the dwell time is chosen to mill approximately 3000 nm of material while traversing the 500 nm radial path and little to no material while traversing the 30 nm radial path, needle 105 can be made. Alternatively, needle 105 and lamella 110 can be separately made as described above and welded together using the FIB and a suitable gas precursor.

Once made or joined together, the lamella 110 and the needle 105 can be welded to the conventional manipulator needle or tomography pin holder 115 using conventional techniques. As explained above, the lamella 110 and tomography pin holder 115 can be welded together by bringing the two into close proximity in the presence of an ion beam and a suitable precursor such as an organometallic gas. In the presence of the ion beam, the precursor will dissociate into a volatile component that is removed by the FIB machine's vacuum system, and a non-volatile component that will deposit on the lamella 110 and/or the pin holder 115 to thereby build a bridge between and connect the two.

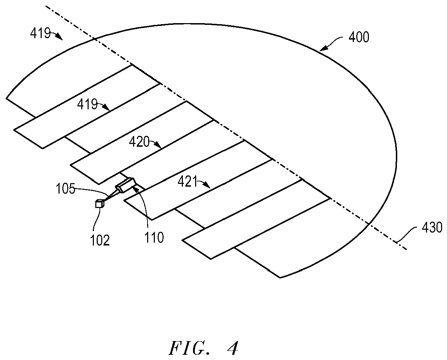

FIG. 4 is an illustration of a second embodiment of mounting a sample 102 on a sample holder 400. The sample holder 400 consists of a conventional copper TEM ½ grid with a 3 mm diameter with multiple mounting fingers 419-421, one of which 420 has a thin lamella 110 welded to it. A fine needle 105 is then attached to the lamella 110 in a similar fashion. The lamella 110 and needle 105 can be made as described above, i.e., as a single piece or as separate pieces welded together using conventional ion beam milling techniques. The sample 102 can then be FIB welded onto the tip of the needle.

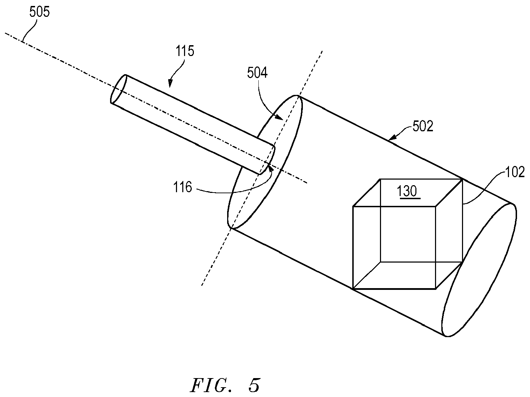

FIG. 5 is an illustration of an alternative embodiment for extracting and mounting a sample on a sample holder. As shown in FIG. 5, a sample 502 in the form of a short cylindrical column can be extracted from a larger piece of material using conventional TEM pillar sample preparation techniques, such as ion beam milling. The larger piece of material can have the region of interest 102 inside (defined here by the cube shape as an illustration to best show the orientation of the region of interest with respect to its orthogonal directions). The region of interest bounded by the 'virtual cube' determines the ultimate diameter and length of the cylinder. For example, the cylinder can be extracted from an integrated circuit, having as a region of interest 102 a feature or component such as a transistor.

The cylindrical column sample 502 can include the region of interest 102, and can be dimensioned so that its height, diameter and length allow appropriate encapsulation of the three orthogonal directions of the region of interest 102. The cylindrical column sample 502 can be extracted from the larger piece of material using methods similar to those used for conventional TEM pillar sample preparation techniques so that it has a principal axis 505 that passes through two diametrically opposed apexes of a virtual cube which encapsulates the region of interest 102. That is, the cylindrical column sample 502 can be extracted so that its principal axis 505 is vertically displaced from a top face 130 of the region of interest 102 by an angle of approximately 35.26 degrees, and is azimuthally displaced so that its projection onto the top face 130 of the region of interest 102 approximately bisects the top face 130 (i.e., is azimuthally displaced by an angle of about 45 degrees). As shown in FIG. 5, a cylindrical column sample 502 extracted in this way can be much more easily and accurately mounted onto a standard TEM tomography pin holder 115 using conventional FIB welding techniques since it has a flat face 504 that can be welded to the flat end 116 of the conventional pin holder 115.

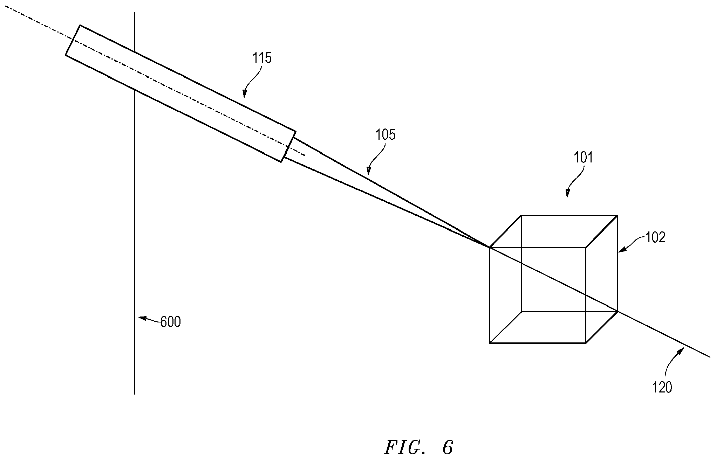

In some embodiments, as shown in FIG. 6, a sample 102 or a cylindrical column sample 502 (containing a region of interest 102) can be mounted on a conventional TEM tomography pin holder 115 or similar which is at an angle of approximately 35.62 degrees (from the horizontal) inside the TEM objective pole piece (imaging) area. In such embodiments, the sample 102 / cylindrical column sample 502 can be easily rotated about symmetry axis 120 by simply rotating the manipulator or pin holder 115 using conventional TEM sample rotation techniques. As explained above, rotating sample 102 / cylindrical column sample 502 in successive 120 degree increments exposes three orthogonal faces of sample (or region of interest) 102 to the electron beam 101, thereby allowing the TEM to capture three orthogonal images of the sample (or region of interest) 102.

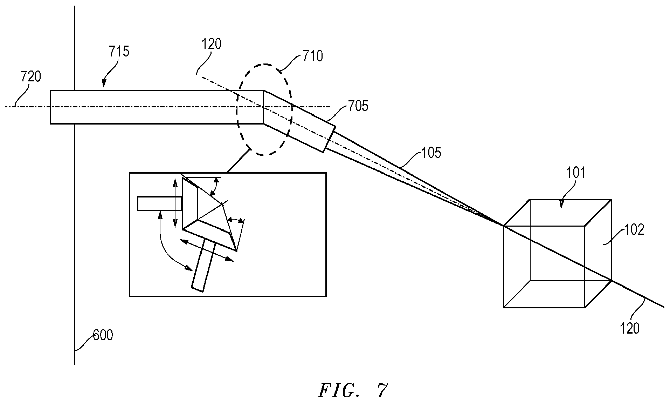

In other embodiments, as shown in FIG. 7, the sample 102 or cylindrical column sample 502 can be mounted on a manipulator 705 that is rotationally coupled via a gear 710 to an arm 715 that enters the side 600 of the TEM sample chamber at a right angle. When the arm 715 is rotated by successive 120 degree angles about its rotational axis 720, the gear 715 transfers the rotational motion from axis 720 to the rotational axis 120 of the manipulator 705 which passes through the diametrically opposed vertices of the sample (or region of interest) 102 as shown. Thus, gear 710 converts successive 120 degree rotations of arm 715 into successive 120 degree rotations about the rotational axis 120 of sample (or region of interest) 102, exposing three orthogonal faces of sample (or region of interest) 102 to the electron beam 101, thereby allowing the TEM to capture three orthogonal images of the sample (or region of interest) 102.

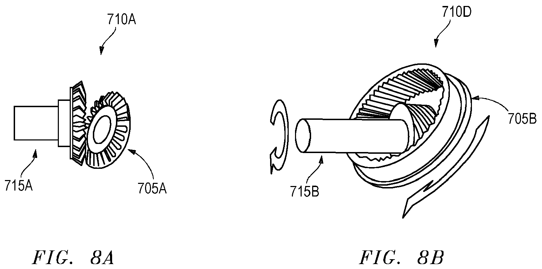

FIGS. 8A and 8B are schematic illustrations of just two types of gear that can be used to transfer rotational motion from a first axis to a second axis. Skilled persons will be able to determine other such mechanisms. As shown in FIG. 8A, an angular bevel gear 710A can be used to transfer the rotational motion from arm 715/715A to manipulator 705/705A to which sample (or region of interest) 102 is attached. Alternatively, as shown in FIG. 8B, a crossed helical gear 710B can be used to transfer rotational motion from arm 715/715B to manipulator 705/705B to which sample (or region of interest) 102 is attached.

Although much of the previous description is directed at features and components of IC devices, the invention could be used to visualize bulk samples of any suitable material. The terms "work piece," "sample," "substrate," and "specimen" are used interchangeably in this application unless otherwise indicated. Further, whenever the terms "automatic," "automated," or similar terms are used herein, those terms will be understood to include manual initiation of the automatic or automated process or step.

In the discussion and claims, the terms "including" and "comprising" are used in an open-ended fashion, and should be interpreted to mean "including, but not limited to ...." To the extent that any term is not specially defined in this specification, the intent is that the term be given its plain and ordinary meaning. The accompanying drawings are intended to aid in understanding the present invention and, unless otherwise indicated, are not drawn to scale. Particle beam systems suitable for carrying out the present invention are commercially available, for example, from FEI Company, the assignee of the present application.

## Claims

1. A method for obtaining orthogonal images of a sample in a charged particle beam apparatus, comprising:
connecting a sample (102) comprising three orthogonal observation faces (130, 140, 150) that are not parallel to each other to a rotatable sample holder (300, 400), the thickness of the sample (102) orthogonal to each of the observation faces being less than 200 nm;
rotating the rotatable sample holder to a plurality of angles, such that for each of the plurality of angles a different one of the three orthogonal observation faces is exposed to and normal to an electron beam (101) generated by the charged particle beam apparatus;
detecting, at each of the plurality of angles, the electrons from the electron beam that are transmitted through the sample (102) for each of the three orthogonal observation faces; and
generating three orthogonal images of the sample from the detected electrons transmitted through the sample at each of the three orthogonal observation faces.

2. The method of claim 1, wherein rotating the rotatable sample holder to a plurality of angles comprises rotating the rotatable sample holder to at least two angles selected from the group consisting of zero degrees, +/- hundred twenty degrees, and two hundred forty degrees.

3. The method of claim 1 or claim 2, wherein connecting a sample comprising three orthogonal faces that are not parallel to each other to a rotatable sample holder comprises connecting a cylindrical column (502) containing a cubic region (102) of interest, the cubic region of interest comprising the three orthogonal faces, to the rotatable sample holder such that the axis of the cylindrical column passes through diametrically opposed apexes of the cubic region of interest.

4. The method of claim 3, wherein connecting the cylindrical column to the rotatable sample holder comprises welding the cylindrical column to the rotatable sample holder.

5. The method of claim 1 or claim 2, wherein connecting a sample comprising three orthogonal faces that are not parallel to each other to a rotatable sample holder comprises:
mounting a cubic sample on a needle such that the axis of the needle passes through diametrically opposed apexes of the cubic sample; and
connecting the needle to the rotatable sample holder.

6. The method of claim 5, wherein connecting the needle to the rotatable sample holder comprises welding the needle to the rotatable sample holder.

7. The method of claim 5, wherein mounting the cubic sample on the needle further comprises:
making the needle in the charged particle beam apparatus via annular focused ion beam milling;
making the cubic sample in the charged particle beam apparatus from a larger sample using a focused ion beam;
welding the needle to the cubic sample so that the axis of the needle passes through the diametrically opposed apexes of the cubic sample; and
separating the cubic sample, mounted onto the needle, from the larger sample.

8. The method of any of claims 1 to 7, wherein the rotatable sample holder is connected to a rotatable arm (715) via a gear (710) at an oblique angle, and the rotatable arm passes through a wall in the charged particle beam apparatus at a right angle.

9. The method of claim 8, wherein rotating the rotatable sample holder to a plurality of angles comprises rotating the rotatable arm to a plurality of angles such that the rotation of the rotatable arm to the plurality of angles is transferred to the rotation of the rotatable sample holder to the plurality of angles by the gear.

## Patentansprüche

1. Verfahren zum Erhalten orthogonaler Bilder einer Probe in einer geladenen Teilchenstrahleinrichtung, Folgendes umfassend:
Verbinden einer Probe (102), die drei orthogonale Beobachtungsflächen (130, 140, 150) umfasst, die nicht parallel zueinander sind, mit einem drehbaren Probenhalter (300, 400), wobei die Dicke der Probe (102), die orthogonal zu jeder der Beobachtungsflächen ist, weniger als 200 nm ist;
Drehen des drehbaren Probenhalters in mehrere Winkel derart, dass für jeden der mehreren Winkel eine verschiedene der drei orthogonalen Beobachtungsflächen einem von der geladenen Teilchenstrahleinrichtung erzeugten Elektronenstrahl (101) ausgesetzt und senkrecht zu diesem ist;
Erfassen der Elektronen aus dem Elektronenstrahl, die durch die Probe (102) für jede der drei orthogonalen Beobachtungsflächen übertragen werden, an jedem der mehreren Winkel; und
Erzeugen von drei orthogonalen Bildern der Probe aus den erfassten Elektronen, die an jeder der drei orthogonalen Beobachtungsflächen durch die Probe übertragen werden.

2. Verfahren nach Anspruch 1, wobei das Drehen des drehbaren Probenhalters in mehrere Winkel das Drehen des drehbaren Probenhalters in wenigstens zwei Winkel umfasst, die aus der Gruppe, bestehend aus Null Grad, +/- hundertzwanzig Grad und zweihundertvierzig Grad, ausgewählt werden.

3. Verfahren nach Anspruch 1 oder 2, wobei das Verbinden einer Probe, die drei orthogonale Flächen umfasst, die nicht parallel zueinander sind, mit einem drehbaren Probenhalter das Verbinden einer zylindrischen Säule (502), die einen kubischen Bereich (102) von Interesse enthält, wobei der kubische Bereich von Interesse die drei orthogonalen Flächen umfasst, mit dem drehbaren Probenhalter derart umfasst, sodass die Achse der zylindrischen Säule durch diametral gegenüberliegende Scheitelpunkte des kubischen Bereichs von Interesse verläuft.

4. Verfahren nach Anspruch 3, wobei das Verbinden der zylindrischen Säule mit dem drehbaren Probenhalter das Schweißen der zylindrischen Säule an den drehbaren Probenhalter umfasst.

5. Verfahren nach Anspruch 1 oder 2, wobei das Verbinden einer Probe, die drei orthogonale Flächen umfasst, die nicht parallel zueinander sind, mit einem drehbaren Probenhalter Folgendes umfasst:
Lagern einer kubischen Probe auf einer Nadel derart, dass die Achse der Nadel durch diametral gegenüberliegende Scheitelpunkte der kubischen Probe verläuft; und Verbinden der Nadel mit dem drehbaren Probenhalter.

6. Verfahren nach Anspruch 5, wobei das Verbinden der Nadel mit dem drehbaren Probenhalter das Schweißen der Nadel an den drehbaren Probenhalter umfasst.

7. Verfahren nach Anspruch 5, wobei das Lagern der kubischen Probe auf der Nadel ferner umfasst:
Herstellen der Nadel in der geladenen Teilchenstrahleinrichtung durch ringförmiges fokussiertes Ionenstrahlfräsen;
Herstellen der kubischen Probe in der geladenen Teilchenstrahleinrichtung aus einer größeren Probe unter Verwendung eines fokussierten lonenstrahls;
Schweißen der Nadel an die kubische Probe derart, dass die Achse der Nadel durch die diametral gegenüberliegenden Scheitelpunkte der kubischen Probe verläuft; und
Trennen der auf der Nadel gelagerten kubischen Probe von der größeren Probe.

8. Verfahren nach einem der Ansprüche 1 bis 7, wobei der drehbare Probenhalter mit einem drehbaren Arm (715) über ein Getriebe (710) in einem schiefen Winkel verbunden ist, und wobei der drehbare Arm durch eine Wand in der geladenen Teilchenstrahleinrichtung in einem rechten Winkel verläuft.

9. Verfahren nach Anspruch 8, wobei das Drehen des drehbaren Probenhalters in mehrere Winkel das Drehen des drehbaren Arms in mehrere Winkel derart umfasst, dass die Drehung des drehbaren Arms in die mehreren Winkel durch das Getriebe auf die Drehung des drehbaren Probenhalters in die mehreren Winkel übertragen wird.

## Revendications

1. Procédé d'obtention d'images orthogonales d'un échantillon dans un appareil à faisceau de particules chargées, le procédé comprenant :
la liaison d'un échantillon (102) comprenant trois faces orthogonales d'observation (130, 140, 150), qui ne sont pas parallèles l'une à l'autre, à un support rotatif d'échantillon (300, 400), l'épaisseur de l'échantillon (102) étant orthogonale à chacune des faces d'observation qui font moins de 200 mm ;
la rotation du support rotatif d'échantillon vers une pluralité d'angles, de sorte que, pour chacun des angles, une face différente parmi les trois faces orthogonales d'observation soit exposée, et ce normalement, à un faisceau électronique (101) produit par l'appareil à faisceau de particules chargées ;
la détection, pour chaque angle de la pluralité d'angles, des électrons qui sont proviennent du faisceau d'électrons et qui sont transmis à travers l'échantillon (102) pour chacune des trois faces orthogonales d'observation ; et
la production de trois images orthogonales de l'échantillon à partir des électrons détectés transmis à travers l'échantillon au niveau de chacune des trois faces d'observation orthogonales.

2. Procédé selon la revendication 1, la rotation du support rotatif d'échantillon selon une pluralité d'angles comprenant la rotation du support rotatif d'échantillon selon au moins deux angles choisis dans l'ensemble comprenant 0°, ± 120° et 240°.

3. Procédé selon la revendication 1 ou la revendication 2, la liaison d'un échantillon qui comprend trois faces orthogonales, qui ne sont pas parallèles l'une à l'autre, à un support rotatif d'échantillon comprenant la liaison d'une colonne cylindrique (502) contenant une région cubique (102) intéressante, la région cubique intéressante comprenant les trois faces orthogonales, au support rotatif d'échantillon de sorte que l'axe de la colonne cylindrique passe par des sommets diamétralement opposés de la région cubique intéressante.

4. Procédé selon la revendication 3, la liaison de la colonne cylindrique à un support rotatif d'échantillon comprenant le soudage de la colonne cylindrique au support rotatif d'échantillon.

5. Procédé selon la revendication 1 ou la revendication 2, la liaison d'un échantillon, qui comprend trois faces orthogonales qui ne sont pas parallèles l'une à l'autre, à un support rotatif d'échantillon comprenant :
le montage d'un échantillon cubique sur une aiguille de sorte que l'axe de l'aiguille passe par des sommets diamétralement opposés de l'échantillon cubique ; et
la liaison de l'aiguille au support rotatif d'échantillon.

6. Procédé selon la revendication 5, la liaison de l'aiguille au support rotatif d'échantillon comprenant le soudage de l'aiguille au support rotatif d'échantillon.

7. Procédé selon la revendication 5, le montage de l'échantillon cubique sur l'aiguille comprenant en outre :
la fabrication de l'aiguille dans l'appareil de faisceau de particules chargées par usinage annulaire au faisceau focalisé d'ions ;
la fabrication de l'échantillon cubique dans l'appareil de faisceau de particules chargées à partir d'un plus grand échantillon à l'aide d'un faisceau focalisé d'ions ;
le soudage de l'aiguille à l'échantillon cubique de sorte que l'axe de l'aiguille passe par les sommets diamétralement opposés de l'échantillon cubique ; et
la séparation de l'échantillon cubique, monté sur l'aiguille, de l'échantillon le plus grand.

8. Procédé selon l'une quelconque des revendications 1 à 7, dans lequel le support rotatif d'échantillon est relié à un bras rotatif (715) par le biais d'une roue dentée (710) suivant un angle oblique, et où le bras rotatif traverse une paroi dans l'appareil à faisceau à particules chargées selon un angle droit.

9. Procédé selon la revendication 8, la rotation du support rotatif d'échantillon selon une pluralité d'angles comprenant la rotation du bras rotatif selon une pluralité d'angles, de sorte la rotation du bras rotatif selon la pluralité d'angles soit convertie en la rotation du support rotatif d'échantillon selon la pluralité d'angles par la roue dentée.
